# EUROPEAN PATENT APPLICATION

(11) **EP 4 715 398 A1**
(43) Date of publication of application: **25.03.2026**
(21) Application number: 25202950.9
(22) Date of filing: 18.09.2025
(51) Int. Cl.: G01R 15/18, G01R 31/12, G01R 19/00

(54) **RESONANT CURRENT SENSOR**

(30) Priority: 23.09.2024 US 202463697776 P
(71) Applicant: Analog Devices International Unlimited Company, Co. Limerick (IE)
(72) Inventor: Niemann, James Alan, Wilmington, 01887 (US); Hurwitz, Jonathan Ephraim David, Limerick (IE)
(74) Representative: Horler, Philip John

(57) **Abstract**

A current sensor system is provided where the self-resonant frequency of a current measurement coil, such as a Rogowski coil, may be modified. The current sensor system comprises a current measurement coil and a resonant frequency modification circuit. The resonant frequency modification circuit is configured to modify a resonant frequency of the current sensor system such that a combined resonant frequency of the current measurement coil and the resonant frequency modification circuit is different from a self-resonant frequency of the current measurement coil.

## Description

### Technical Field

The present disclosure relates to a current sensor system comprising a resonant frequency modification circuit and to a method of modifying the resonant frequency of a current sensor.

### Background

An arc-fault is the arcing of electrical current between two contact points on a single wire or on multiple wires. Arc-faults may occur when there is a small break in a wire, with the current arcing across the break to another break in the same wire or a break in one or more adjacent wires. For example, an arc-fault may occur between a break in a live wire and a break in an adjacent neutral wire when the insulative material between them has degraded. Often, in alternating current (AC) home or industrial power networks, the arcing occurs at a point of high potential in the AC cycle, where there is a larger potential difference between the contact points.

Arc-faults, due to energy dissipated across the arc generating heat in the arc, can cause the conductor (often copper) to heat up and further break down the surrounding insulative material, which may lead to electrical fires. In some instances, when the conductor is heated to a high level, conductive material may spit out and come into contact with the surrounding building fabric. This is particularly problematic in wood or timber-framed buildings. To prevent this, arc-fault circuit interrupt (AFCI) systems monitor the current in a wire(s) and attempt to determine whether an arc-fault is occurring. If it is determined that an arc-fault is occurring, or has occurred, the AFCI may stop or cut-off the supply of electricity to the wire(s), allowing proper diagnosis by an electrician at a later time.

It is desirable to increase the accuracy of arc-fault detection. In some cases, arc-faults may be erroneously detected when certain loads draw complex current waveforms, for example when, a working and connected motor is switched on or off. Further, arc faults occur quickly due to the fast rise time and may last a short period of time, requiring detection within a specific frequency band. There is a need to accurately determine the presence of an arc-fault.

### Summary

According to a first aspect of the present disclosure, there is provided a current sensor system comprising: a current measurement coil configured to measure the current flowing through a conductor, the current measurement coil having a self-resonant frequency; a resonant frequency modification circuit coupled to the current measurement coil, the resonant frequency modification circuit configured to modify a resonant frequency of the current sensor system such that a combined resonant frequency of the current measurement coil and the resonant frequency modification circuit is different from the self-resonant frequency of the current measurement coil.

According to a second aspect of the present disclosure, there is provided a method of measuring current using a current sensor system comprising a current measurement coil having a self-resonant frequency and a resonant frequency modification circuit, the method comprising: modifying a resonant frequency of the current sensor system, such that a combined resonant frequency of the current measurement coil and the resonant frequency modification circuit is different from the self-resonant frequency of the current measurement coil.

According to a third aspect of the present disclosure, there is provided a current sensor system comprising: a current measurement coil configured to measure the current flowing through a conductor, the current measurement coil having a self-resonant frequency; a variable resonant frequency modification circuit coupled to the current measurement coil, the resonant frequency modification circuit configured to modify the resonant frequency of the current sensor system by: modifying an effective capacitance coupled across the measurement coil such that a combined resonant frequency of the current measurement coil and the variable resonant frequency modification circuit is different from the self-resonant frequency of the current measurement coil.

### Drawings

Aspects of the disclosure are described, by way of example only, with reference to drawings in which:
Figure 1 is a diagram of a Rogowski coil;
Figure 2a is a simplified diagram of a current measurement coil;
Figure 2b is a simplified diagram of a differential current measurement coil;
Figure 3 is a block diagram of a current sensor system comprising a resonant frequency modification system;
Figure 4 is a circuit diagram of a current sensor system comprising a resonant frequency modification system.
Figure 5 is a graph of the gain of a current measurement coil at different frequencies;
Figure 6 is a block diagram of a current sensor system comprising a variable frequency modification system;
Figure 7 is a circuit diagram of a current sensor system comprising a variable frequency modification system with a pair of switched capacitors;
Figure 8 is a circuit diagram of a current sensor system comprising a variable frequency modification system with four switched capacitors;
Figure 9 is a block diagram of a current sensor system comprising an active variable frequency modification system;
Figure 10 is a block diagram of a current sensor system comprising an active variable frequency modification system wherein an attenuated version of the measurement coil voltage is fed to a capacitor;
Figure 11 is a circuit diagram of a current sensor system comprising an active variable frequency modification system comprising buffer amplifiers;
Figure 12 is a circuit diagram of a current sensor system comprising an active variable frequency modification system comprising a transconductance amplifier;
Figure 13 is a block diagram of a current sensor system comprising an active variable frequency modification system for a differential measurement coil;
Figure 14 is a circuit diagram of a current sensor system comprising buffer amplifiers and a transconductance amplifier;
Figure 15 is a circuit diagram of a current sensor system with the output switched to a new kind of output amplifier.

### Detailed Description

Currents may be measured using known current sensors, such as rate of change of current sensors (di/dt sensors) or Rogowski coils. These coils measure the rate of change or differential of the current in a conductor under test. An integrator may be coupled to the output of the current sensor, receive the voltage output from the current sensor, integrate this voltage and thus determine the current drawn.

Due to arcing, the current drawn during an arc-fault event can be substantially greater than during normal operation. The arc-fault event may last a very short period of time and include a very high frequency oscillation, for example the arc-fault may occur only during the highest potential point of the AC cycle. Measuring the voltage across the phase and neutral of the electrical network can be used to determine the potential when the current event occurs and be used to help determine an arc fault. The arc fault may induce a high frequency spike of current that contains very high frequencies. Arc faults can be characterised by the energy they contain in the frequency ranges between >200kHz, >500kHz, >1MHz, > 5MHz, > 10MHz, and <1MHz, <5MHz, <10MHz, <50MHz, <20MHz, <10MHz, <5MHz. For example, arc-faults may be characterised by the energy that they contain in the frequency ranges 200kHz-1MHz, 1MHz-50Mhz, 1MHz-20MHz, 1MHz-10MHz, 1MHz-5MHz.

Current sensor coils, such as Rogowski coils, may have a self-resonant frequency, at which the detection of current is most sensitive and produces the greatest output signal gain or best signal to noise ratio. Current measurement coils may be, in some cases, represented as inductors, and therefore operate in a similar manner to the resonant effects of an inductor. This self-resonant frequency may be a function of a design of the coil (for example, resistance, length of coil, track width used to create the coil).

A resonant frequency modification circuit may be provided that is coupled to the current measurement coil (for example across the current measurement coils outputs). The resonant frequency modification circuit is configured to modify the resonant frequency of the complete current sensor system (a combined resonant frequency of the current measurement coil and modification circuit) to be different from a self-resonant frequency of the current measurement coil alone.

The combined resonant frequency of the current sensor system may be set within the frequency range of interest for an arc-fault, providing greater accuracy in the detection of arc faults. The resonant frequency of the current sensor system may be set within any frequency range of interest to look for different conditions (for example, the resonant frequency may be set to the frequency of one or more different fault types in an electrical system, which may occur at different frequencies, providing improved SNR for measurement at the resonant frequency). In some cases, the resonant frequency modification circuit may be a variable resonant frequency modification circuit, configurable to modify or change the combined resonant frequency for the current sensor system. This allows the resonant frequency to be modified based on what the current sensors system is looking for (for example, a frequency of interest for an arc fault or a frequency of the system under test).

Modifying the combined resonant frequency may comprise modifying a capacitance or effective capacitance coupled across or to the current measurement coil.

Modifying the resonant frequency of the current measurement coil to match the frequency band within which the arc fault occurs allows the system to determine more accurately whether an arc fault has occurred. Further, the resonant frequency may be changed or modified to allow multiple bands of interest to be monitored over time, allowing the current sensor to look for multiple different conditions, such as arc-faults or short circuits. The modification of the resonant frequency of the current measurement coil may be provided using any suitable passive or active system.

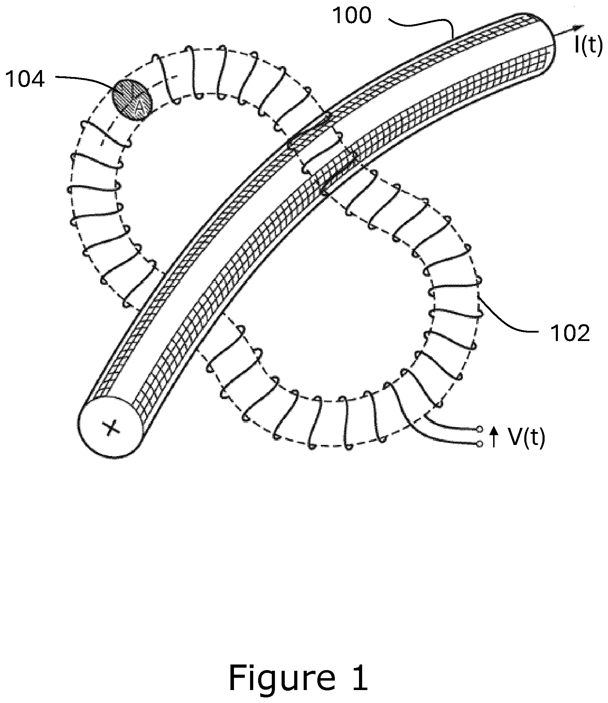

Figure 1 is a diagram of a current sensor coil. So as to measure the current I(t) flowing through a current carrying conductor 100, a measurement coil 102 is arranged such that the current carrying conductor 100 passes through the measurement coil. The measurement coil 102 is wound as a helix, such that a loop or turn of the helix encloses a cross sectional area 104, A. The current carrying conductor 100 may be, for example, a bus-bar.

As the current I(t) in the current carrying conductor 100 changes, the field generated by the current also changes. The positioning of the measurement coil causes a voltage to be induced in the measurement coil 102 which is proportional to the rate of change of current, dI/dt. Therefore, integrating the output v(t) of the measurement coil provides a value proportional to the current. Each turn or loop of the coil forms a measurement area 104 in a plane perpendicular to the progression of the current carrying conductor. The greater the output voltage V(t) for a certain current, the greater the sensitivity of the coil. Having greater sensitivity allows the current sensor coil to determine or detect smaller currents in the presence of noise.

The Rogowski coil of Figure 1 is a single-ended Rogowski coil, including one measurement coil 102 which progresses around the conductor 100. A current sensor may include more than one measurement coil and be arranged to provide a differential output. Further, the measurement coil or coils may be provided on a printed circuit board or substrate.

Current measurement coils have a self-resonant frequency. This term represents the interaction between the coil's fundamental inductance (a positive reactance) and capacitance (negative reactance). When these impedances combine in a parallel resonant circuit they can cancel mathematically to a high impedance, maximizing the voltage across the component to a stimulus. The self-resonant frequency of the coil will be a function of the PCB stack-up (for a PCB-implemented coil), the inner and outer dimensions that are often limited by the conductor diameter, the galvanic isolation method, the available footprint, amongst other factors.

Most often, when measuring a current using a current measurement coil, one attempts to keep the self-resonance away from band of interest. The self-resonant frequency introduces a peak in the frequency response (magnitude) and a sudden phase change. As such, if the band of interest includes the self-resonant frequency, the magnitude and phase of the measured signals will vary substantially across the band of interest. For example, when measuring the energy consumption of a system by measuring current using a current measurement coil and voltage using a voltage sensor of any suitable type, the band of interest may be less than 150kHZ while the self-resonant frequency may be above a few MHz or a few 10s of MHz.

However, the inventors have realized that being able to tune the resonant frequency of the coil allows more selectivity of that frequency range by increasing the coils response relative to frequencies outside the resonance zone. This allows measurements with a greater sensitivity to be taken at the resonant frequency. This resonance is advantageous in a measurement circuit providing not only gain but also a frequency selective measurement.

Designing a current measurement coil to have a natural self-resonant frequency at a frequency of interest increases the design complexity for the coil, where other factors (such as number of turns, resistance, coil layout to reduce noise pickup) may take priority. Further, it is difficult to design a current measurement coil with a natural self-resonant frequency (caused by the inductance and parasitic capacitance of the coils) that is relatively low (for example <200kHz, <500kHz, <1MHz). As such, modifying the resonant frequency to be less than the self-resonant frequency of the coil may be particularly advantageous.

Noise is often the limiting factor determining measurement sensitivity. This is the case behind the chopper stabilized amplifier and the lock-in amplifier, whereby the parameter to be measured is identical across frequency and noise is the main issue. In other applications such as radio, and AFCI (arc fault circuit interrupt), the issue is not only noise but also information selectivity.

The self-resonant frequency of a current sensor coil is dependent on the intrinsic properties of the coil itself and the impedance presented to the coil from the measurement or processing circuit coupled to the coil. The self-resonant frequency is a fixed quantity that is not changed following manufacture. Providing a current sensor system or measurement coil with a modifiable or changeable resonant frequency allows the frequency at which the greatest sensitivity is present to be changed. It may be desirable to change the detector bandwidth to look for different characteristics of the signal to optimise the application of detection, for example to avoid an interferer or maximise the signal strength of a given response.

In some instances, if a shunt, hall sensor or current transformer is used for current sensing, it may be followed by a separate (often active) tuning/filter circuit for frequency selectivity prior to detection. If a circuit requires many different frequencies of measurement, a means of switching between many of these fixed circuits must be implemented. This may involve radio front ends, Intermediate Frequency (IF) tuned circuits, and antenna tuning where the fixed antenna values (changing with frequency) require matching to a fixed source impedance (usually 50 ohms). This requires more active circuitry and cost. It is desirable from a signal-to-noise-ratio (SNR), cost and power viewpoint to use resonance to select the frequency of interest over other active and digital (ADC+FFT) approaches.

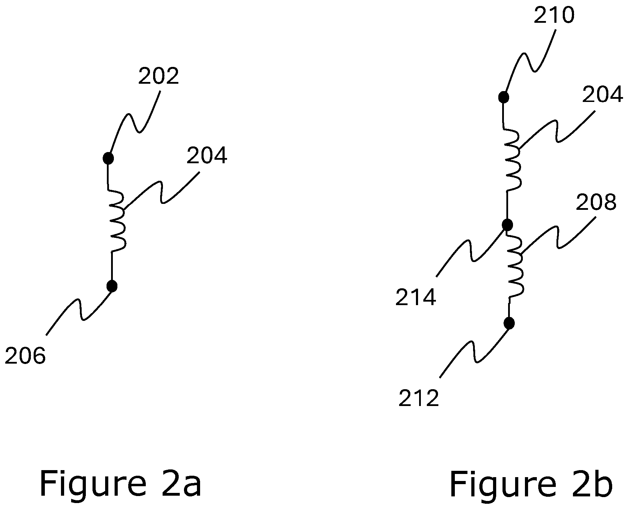

Figure 2a is a diagram of an equivalent circuit of a current measurement coil. The current sensor coil 204 has a first output node or terminal 202 and a second output node or terminal 206. Current sensor coils may be coupled in series to improve sensitivity or create a differential output signal. Figure 2b shows a differential system comprising a first current measurement coil 204 and a second measurement coil 208. The differential system comprises a first output node or terminal 210 and a second output node or terminal 212. The current measurement coils 204, 208 are coupled together at node or terminal 214. Node or terminal 214 may be coupled to a reference voltage or ground. As such, the output terminals 210, 212 provide a differential output signal when the terminal 214 is coupled to a reference voltage. Other current measurement coils, comprising more than two measurement coils are not represented here, but should be understood to be compatible with this disclosure.

The output terminals of either current measurement may be coupled to further processing or logic circuitry, for example, an integrator to determine the output current from the measured differential signal, amplifier, buffers, processors, micro-processors. Further, the current sensor may form part of wider measurement systems, such as utility meters, current measurement systems, or power measurement systems (when the current is measured in conjunction with a voltage).

Figures 2a and 2b represent the measurement coils as inductors as the equivalent component of a measurement coil for clarity. As would be understood, the coils may have other parasitic values (resistance, capacitance) that are not shown in the figures.

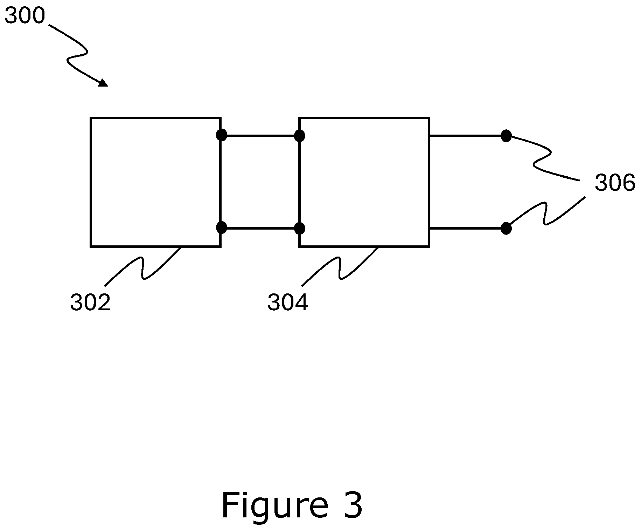

Figure 3 is a diagram of a current sensor system 300 with a current measurement coil 302 coupled to a resonant frequency modification circuit 304. System 300 comprises a current measurement coil 302 and a resonant frequency modification circuit 304. The current measurement coil 302 may be any current measurement coil or combination of measurement coils. For example, it may comprise one or more current measurement coils coupled in a single-ended or differential fashion as shown in Figures 2a and 2b, or any other suitable coil configuration. The current measurement coil 302 is coupled to the resonant frequency modification circuit 304. The resonant frequency modification circuit 304 is coupled in parallel with the current measurement coil 302. The resonant frequency modification circuit 304 acts to modify the resonant frequency of the current sensor system 300 to be different than the natural self-resonant frequency of the current measurement coil 302 alone. The combined resonant frequency of the current measurement coil 302 and the resonant frequency modification circuit 304 is different than the resonant frequency of the current measurement coil 302 alone. This is achieved through the combination of the self-resonant frequency of the current measurement coil 302 and the resonant frequency of the resonant frequency modification circuit 304.

The resonant frequency modification circuit 304 may comprise one or more reactive components, which act with the parasitic reactance of the current measurement coil 302 to modify the resonant frequency of the current sensor system 300. This allows the region or frequency of greatest sensitivity to be changed. In particular, the resonant frequency modification circuit 304 may comprise reactive components such as capacitors or inductors, which present a capacitance or inductance across the output terminals of the current measurement coil 302. At the resonant frequency, the reactance's of the current measurement coil 302 and the resonant frequency modification circuit 304 cancel, creating an effective open circuit and the greatest possible gain and sensitivity. The current sensor system 300 provides an output signal at output nodes or terminals 306.

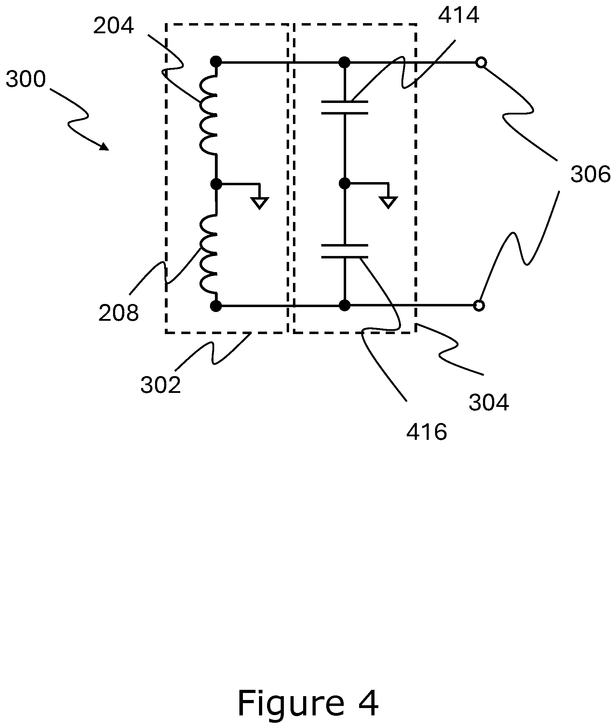

Figure 4 is a diagram of a current sensor system 400, comprising a current measurement coil 302 and a resonant frequency modification circuit 304. The components are shown as equivalent components. The current measurement coil shown in Figure 4 is a differential current measurement coil, comprising a first coil 204 (represented by an inductance) and a second coil 208 (represented by an inductance), however as stated previously any of this disclosure may be implemented with single-ended or differential current measurement coils. The inductance of each of the coils is dependent on the measurement coil that is used and represents the coils fundamental inductance - and as such may be any suitable inductance. The mid-point or node, at which the coils are coupled to one another may be coupled to any suitable reference voltage or ground to achieve a differential system. In a single ended system, the mid-point may be floating or not coupled to anything. If the mid-point of the coils (204, 208) is coupled to a reference voltage or ground, the midpoint of the capacitors 414, 416 is couple to the same reference voltage or ground.

A current under test passing through a conductor that threads through the centre of the collection of coils may generate a voltage across the output nodes or terminals 306, which as described previously may be coupled to further system, such as integrators, amplifiers etc.

Resonant frequency modification circuit 304 comprises a first capacitor 414 and a second capacitor 416 coupled across the current measurement coils. The mid-point of the capacitors is coupled to ground, however it may be coupled to any suitable reference voltage, left floating or the same reference voltage coupled to the mid-point of the current measurement coils L1 and L2. The ground may be an AC ground. Further, only a single capacitor may be provided. The system of Figure 4 may provide a fixed combined resonant frequency, and thus the resonant frequency modification circuit 304 may be referred to as a fixed resonant frequency modification circuit.

The capacitors of the resonant frequency modification circuit 304 act to change the resonant frequency of the current measurement system 300 compared to the self-resonant frequency of the current measurement coils 302 alone, such that a combined resonant frequency of the current measurement coil and the resonant frequency modification circuit is different from the self-resonant frequency of the current measurement coil. The capacitors C1, C2 combine in parallel with the inductances of the current measurement coil 302, modifying the resonant frequency of the current measurement system.

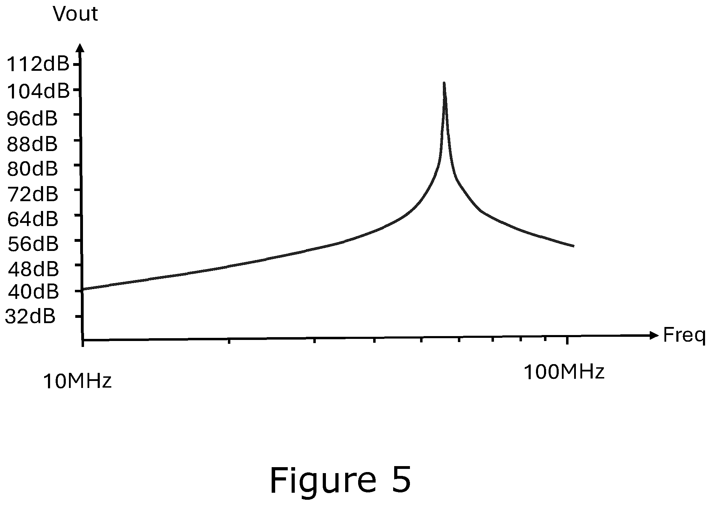

Figure 5 shows the output voltage of the current sensor system 302 in decibels over a range of frequencies. At the resonant frequency, the output voltage is significantly higher than at surrounding frequencies. By modifying the values of the capacitors C1, C2, the resonant frequency may be selected. As such, the values of the capacitors 414, 416 may be chosen to achieve a desired combined resonant frequency of the current sensor system 300. The resonant frequency may be selected during manufacture, and values of the capacitors chosen in dependence on this. Where the resonant frequency modification circuit 304 comprises inductors, the inductance may be modified to modify the resonant frequency of the current sensor system 302.

Whilst Figure 4 shows a system comprising two current measurement coils 204, 208, the system may instead comprise one current measurement coil 204, or more than two current measurement coils, coupled in differential or single-ended configurations. The resonant frequency modification circuit 304 may comprise two capacitors coupled in parallel across the measurement coil as shown in Figure 4. Alternatively, it may comprise one capacitor or two or more capacitors. The capacitors may be coupled in the same configuration as the measurement coils (i.e. single-ended, differential) or in a different arrangement. Where the measurement coil is single-ended (e.g. one coil), one or more capacitors may be coupled across the coil without a centre tap.

The resonant frequency modification circuit 304 provides a fixed resonant frequency for the current sensor system 300. However, resonant frequency modification circuits 304 may be provided that allow the resonant frequency to be changed over time, allowing the resonant frequency to be modified depending on the use-case or application, providing higher sensitivity at different frequencies.

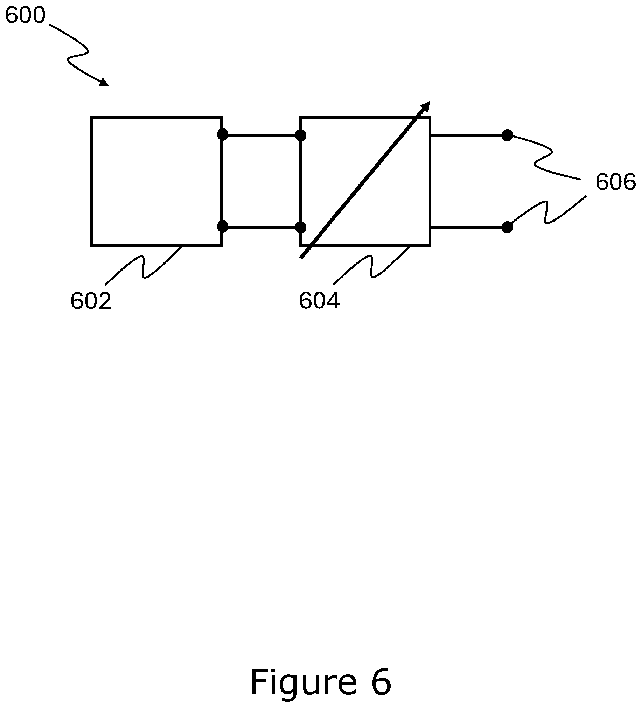

Figure 6 shows a current sensor system 600 with a current measurement coil coupled to a variable resonant frequency modification circuit. System 600 comprises a current measurement coil 602 and a variable resonant frequency modification circuit 604. The variable resonant frequency modification circuit 604 is a variable circuit, configured to provide a changeable or modifiable resonant frequency for the current sensor system 600. The variable resonant frequency modification circuit 604 may present a variable capacitance and/ or inductance across the outputs of the current measurement coil 602, in parallel with the current measurement coil. This capacitance and/ or inductance modifies the resonant frequency of the current sensor system. For example, the variable resonant frequency modification circuit 604 may be configured to modify an effective capacitance across the measurement coil 602 to modify the combined resonant frequency.

The variable resonant frequency modification circuit 604 may comprise any system capable of modifying the capacitance coupled in parallel across the outputs of the current measurement coil 602. For example, the variable resonant frequency modification circuit 604 may be an active system (which actively modifies the effective capacitance across the measurement coil 602) or a passive system (comprising one or more passive components that may be configurably connected across the current measurement coil).

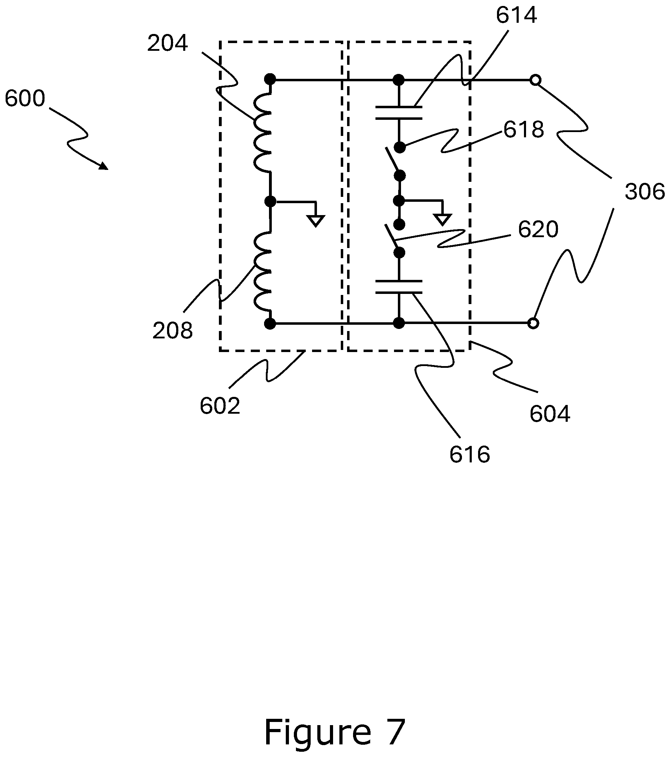

Figure 7 is a diagram of a current sensor system 600, comprising a current measurement coil 602 and a resonant frequency modification circuit 604. A number of parts of Figure 7 are the same as those shown in Figure 3 and will not be described here for brevity. The variable resonant frequency modification circuit 604 comprises a switched system, allowing reactive components (capacitors or inductors) to be coupled or de-coupled across the measurement coil 602. Figure 7 shows a switched capacitor arrangement, configured to couple or de-couple capacitors across the current measurement coil 602. As such, the capacitance presented across the current measurement coil 602 can be modified during operation of the current sensor 600 post manufacture, allowing the combined resonant frequency of the system 600 to be controlled or changed.

The variable resonant frequency modification circuit 604 of Figure 7 includes a first capacitor 414 and a second capacitor 416 coupled across current measurement coil 602. A midpoint of the capacitors is coupled to a reference voltage or ground using or through a first switch 618 and a second switch 620. The first switch 618 and second switch 620 may be selectively controlled or configured to close or open, coupling the capacitors in parallel across the current measurement coil or de-coupling the capacitors from that connection. This changes the capacitance presented the current measurement coil 602 and thus changes the resonant frequency of the current measurement system 600.

The capacitance coupled in parallel across the current measurement coil 602 is greater when the switches are closed than when the switches are open. As such, the system of Figure 7 may have two selectable resonant frequencies (one when the switches are closed and one when the switches are open).

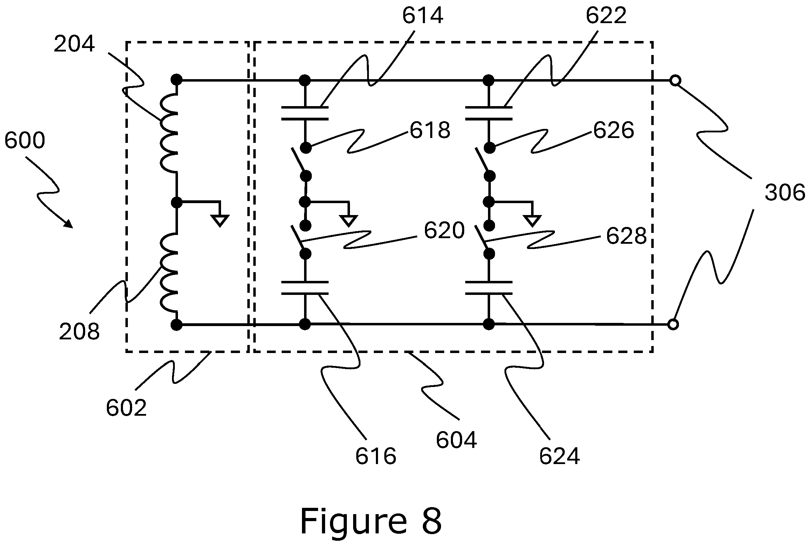

Figure 8 is a diagram of a current sensor system 600, comprising a current measurement coil 602 and a resonant frequency modification circuit 604. A number of parts of Figure 8 are the same as those shown in Figure 3 and Figure 7 and will not be described here for brevity. The variable resonant frequency modification circuit 604 comprises a switched capacitor arrangement comprising two or more individually controllable switched capacitors. The variable resonant frequency modification circuit 604 is configured to couple or de-couple the capacitors across the current measurement coil 602. As such, the capacitance presented across the current measurement coil 602 can be modified during operation of the current sensor 600 post manufacture, allowing the combined resonant frequency of the system to be controlled or changed. As there are a plurality of switched capacitors, multiple resonant frequencies may be selected through coupling different capacitances across the current measurement coil 602.

Figure 8 includes a third capacitor 622 and a fourth capacitor 624, coupled to a reference voltage through switches 626 and 628. The third 622 and fourth 624 capacitors may be coupled across the current measurement coil 602 in the same manner as the first 614 and second 616 capacitors. The third capacitor 622 and fourth capacitor 628 may have difference capacitances compared to the first capacitor 614 and second capacitor 616. As such, when the first 614 and second 616 capacitor are coupled across the measurement coil 602, the resonant frequency will be different to when the third 622 and fourth 624 capacitors are coupled across the measurement coil 602. This provides control of the resonant frequency of the current sensor 602, allowing the sensitivity of the output to be selected depending on the signal under test.

Whilst four capacitors are shown in Figure 8, coupled in two pairs across the current measurement coil 602, further capacitors or inductors may be included to increase the controllability of the system resonant frequency. Further, more than one capacitor may be coupled across the current measurement coil 602 at the same time. For example, all four switches shown in Figure 8 may be closed at the same time, presenting a different capacitance across the measurement coil 602 compared to when only two switches are closed. The capacitors may have the same capacitance or different capacitances. The component values may be selected in dependence on the system use case to provide resonance at frequencies of interest, such as frequencies at which arc-faults occur.

As noted previously, the capacitors shown in Figures 7 and 8 are shown in pairs coupled in parallel across the current measurement coil, with a mid-point coupled to a reference.

However, depending on the coil type 602 (e.g. the number of coils, differential or single-ended coupling) only a single capacitor may be provided in each parallel connection, or more than two capacitors may be provided in each parallel connection. Where the current measurement coil 602 is differential, the capacitance coupled across the first measurement coil 204 and the second measurement coil 208 may be different, allowing each of the measurement coils to have a different resonant frequency.

The switched capacitor arrangement shown in Figures 4, 7 and 8 may comprise other components that modify the resonant frequency, such as inductors. The resonant frequency modification circuits 304, 604 may be controlled by a controller, processor, micro-processor, FPGA, ASIC amongst other control systems or circuits. The control system may act to selectively control the coupling of the capacitors to modify the resonant frequency of the current sensor system 300, 600.

In addition, or as an alternative to a switched capacitor circuit, the variable resonant frequency modification circuit 604 may be an active system, configured to variably tune the resonant frequency. For example, the resonant frequency modification circuit 604 may comprise a system configured to tune a capacitor or other reactive component coupled to the measurement coil 602 using a variable gain voltage or transconductance amplifier to modify the effective capacitance of the capacitors. This may be achieved by modifying the voltage coupled across the capacitor or the current that flows into the capacitor. This provides a system that is not limited by the number of switched capacitors included in the resonant frequency modification circuit 604, but instead offers a wider range of possible resonant frequencies to be selected or tuned post-manufacture.

Capacitors and inductors change their frequency response as a result of the rate that energy is provided to or discharged from these components. Since the resonant behavior is related to how fast energy can be provided to or discharged from a component, if energy is prevented from moving in and out of the current measurement coil (into the capacitor), the change in combined current sensor resonance due to the added capacitor of the resonant frequency modification can be eliminated by forcing zero current (or zero Cdv/dt) into the capacitor. The mechanism may be implemented by taking a signal from the coil (which is coupled to a first plate of the capacitor), amplifying or attenuating the signal through a gain stage, and then feeding back the scaled output to the other plate of the capacitor. This feedback loop effectively changes the perceived capacitance, allowing for tuning of the coil's resonant frequency.

Put another way, a first plate or connection of the capacitor may be coupled to the measurement coil 602. A second plate or connection of the capacitor may be coupled to a variable voltage. Whereas in the preceding description, the voltage across the capacitor or capacitors has been the same as the voltage across the output of the measurement coil 602, instead the voltage across the capacitor may be modified to be an attenuated version of or a gained version of the voltage across the measurement coil 602. This may be achieved by modifying the voltage coupled to the second plate of the capacitor.

Any suitable system may be provided to achieve this.

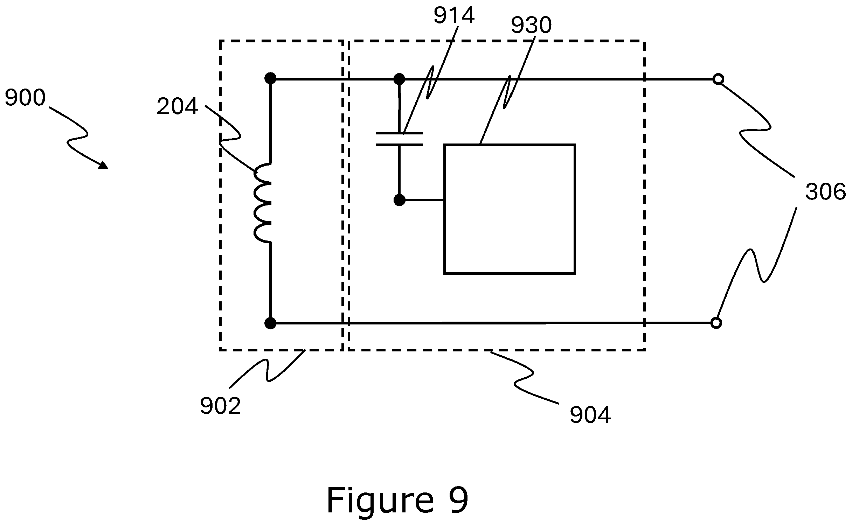

Figure 9 shows a current sensor system 900 comprising a current measurement coil 902. The current measurement coil is a single-ended or single measurement coil 204. A single measurement coil 204 is provided for ease of understanding. A variable resonant frequency modification circuit 904 comprises a first capacitor 914 and a variable voltage system 930. The first plate or connection of capacitor 914 is coupled to the current measurement coil 204. The second plate or connection of capacitor 914 is coupled to the variable voltage system 930. As such, the first plate of the capacitor 914 is coupled to the same voltage as a node of the measurement coil 204. The voltage coupled to the second plate of the capacitor 914 is variable and controlled by the variable voltage system 930.

The variable voltage system 930 is configured to modify the voltage coupled to the second plate of the capacitor 914. This changes the voltage across the capacitor 914 and thus the energy that flows into the capacitor, changing the resonant frequency of the capacitor 914. In turn, this changes the resonant frequency of the combined resonant frequency of the current sensor system 900. The voltage applied to the second plate of the capacitor 914 may be a scaled (amplified or attenuated) version of the voltage across the current measurement coil 204.

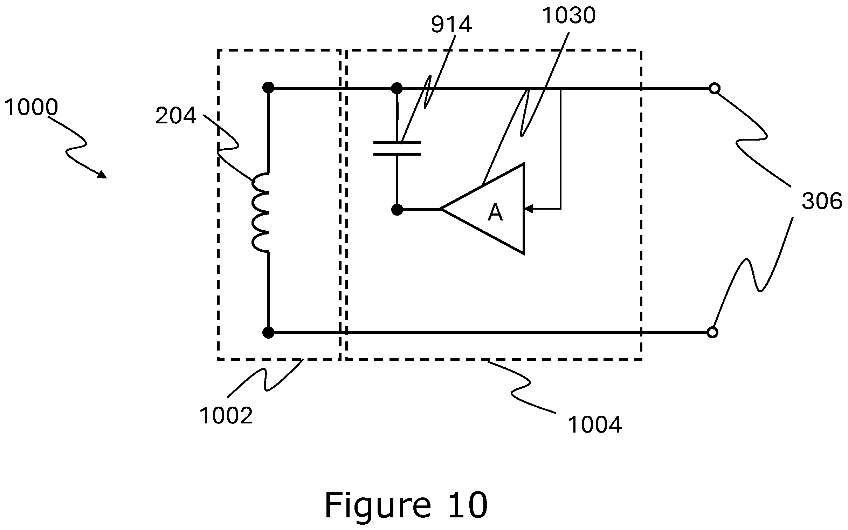

Figure 10 shows a current sensor system 1000 comprising a current measurement coil 1002. The amplifier 1030 applies a variable gain "A" to amplify or attenuate the voltage of the coil. An input of the amplifier is coupled to the measurement coil (and the first plate of the capacitor 914) and an output of the amplifier 1030 is coupled to a second plate of the capacitor 914. The amplifier 1030 applies a voltage to the second plate of the capacitor 914 that is a scaled (amplified or attenuated) version of the voltage across the current measurement coil 204. The amplifier 1030 is configured to modify the combined resonant frequency by modifying the effective capacitance of the capacitor 914.

If the gain of the amplifier 1030 "A" is set to unity, the voltage across the capacitor is zero, as the same voltage is coupled to both plates of the capacitor 914. In this case, the capacitor 914 does not effect the resonant frequency, and the combined resonant frequency is the same as the self-resonant frequency of the measurement coil 204.

If the gain "A" of the amplifier 1030 is less than unity (<1), a voltage is present across the capacitor 914, causing a change in the combined resonant frequency. Similarly, if the gain "A" of the amplifier 1030 is greater than unity (>1), a voltage is present across the capacitor 914, causing a change in the combined resonant frequency. Changing the gain of the amplifier, and the voltage on the second plate of the capacitor 914 therefore changes the combined resonant frequency of the current sensor system 1000 by changing the effective capacitance across the measurement coil 204.

The amplifier 1030 may be implanted in any suitable manner.

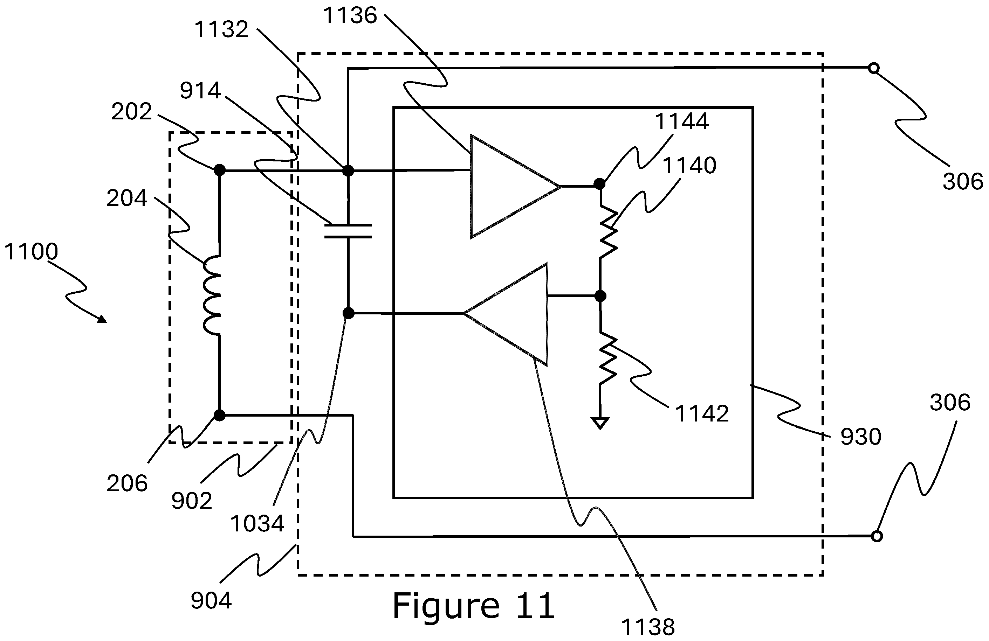

Figure 11 shows a current sensor system 1100 comprising a current measurement coil 902 and a variable resonant frequency modification circuit 904, similar to those shown in Figure 10. The resonant frequency modification circuit comprises a first amplifier 1136, a second amplifier 1138 and a potential divider comprising a first resistor 1140 and a second resistor 1142.

The first node 202 of the current measurement coil 204 is coupled to the first plate or node 1132 of the capacitor 914. The first node 202 of the current measurement coil 204 is also coupled to a first amplifier 1136. The first amplifier 1136 may be a buffer or attenuating amplifier 1136 configured to receive, as an input, the voltage output from the first node 202 of the current measurement coil 204.

The buffer amplifier 1136 outputs the voltage across the coil to a first node 1044 of the potential divider comprising resistors 1140 and 1142. Varying the resistance of resistor 1140 or 1142 (or the ratio between these resistors) modifies the proportion of the voltage across the measurement coil 204 that is supplied to an input of the second amplifier 1138. The second amplifier 1138 then outputs to a second plate or node 1134 of the capacitor 914. In this way, by modifying the potential divider 1140, 1142, the variable resonant frequency modification circuit 904 may operate to modify the voltage coupled to the second plate 1134 of the capacitor 914, thus modifying the rate at which energy may enter the capacitor and therefore the resonant frequency of the capacitor and the current sensor system 1100.

By setting the resistance of the first resistor 1140 to be greater than the second resistor 1142, a greater voltage appears across capacitor 914. By setting the resistance of the first resistor 1140 to be lower than the second resistor 1142, a lower voltage appears across capacitor 914.

Energy moves out of the current measurement coil 204 faster (and provides a higher resonant frequency) when current is prevented from flowing into the capacitor 914. Preventing this current is achieved by buffering the coil voltage (received as an input to the amplifiers) and using this to bootstrap the capacitor voltage to be zero (by changing the voltage on the second plate). The buffered voltage can be attenuated variably using the potential dividers and resistors 1140 and 1142 to gradually add the effects of the capacitor to the circuit by increasing the voltage across the capacitor - allowing the fixed capacitor to behave like a smaller capacitor or variable capacitor, effectively changing the resonant frequency.

The amplifiers shown in Figure 10 are represented with minimal connections for ease of understanding. However, the amplifiers may be any suitable inverting or non-inverting configuration, and may further comprise one or more resistors coupled between their inputs and/or outputs configured to provide a gain.

In place of the voltage amplifier, a transconductance amplifier may be used. Transconductance amplifiers output a current proportional to their input voltage.

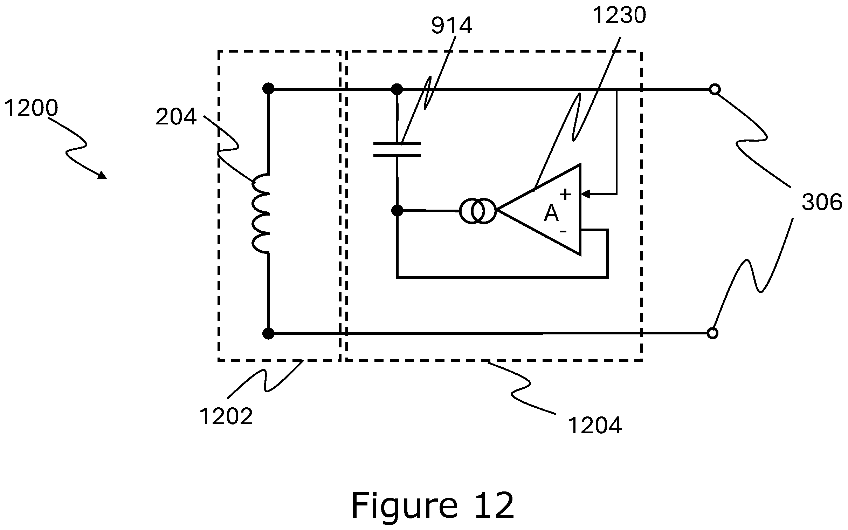

Figure 12 shows a current sensor system 1200 comprising a current measurement coil 902 and a variable resonant frequency modification circuit 1204, similar to those shown in Figure 10. However, in place of the voltage amplifier 1030, a transconductance amplifier 1230 is coupled between a first and second plate of the capacitor 914. The transconductance amplifier 1230 may supply a current (or no current) to the capacitor to charge the capacitor, allowing charge to flow between the current measurement coil 204 and the capacitor 914. The value of the current supplied to the capacitor by the transconductance amplifier (which is dependent on the voltage of the coil 204 and the gain "A" of the amplifier) modifies the combined resonant frequency of the current measurement oil 205 and the capacitor 914.

The non-inverting input of the amplifier 1230 is coupled to the measurement coil 204 and the first plate of the capacitor 914. The inverting input of the amplifier 1230 is coupled to the output of the amplifier. The amplifier 1230 may have a high impedance transconductance output instead of a low impedance output stage.

The previous figures describe active modification of the capacitance in a single-coil or single-ended system. However, the same techniques may be applied to a differential current measurement coil.

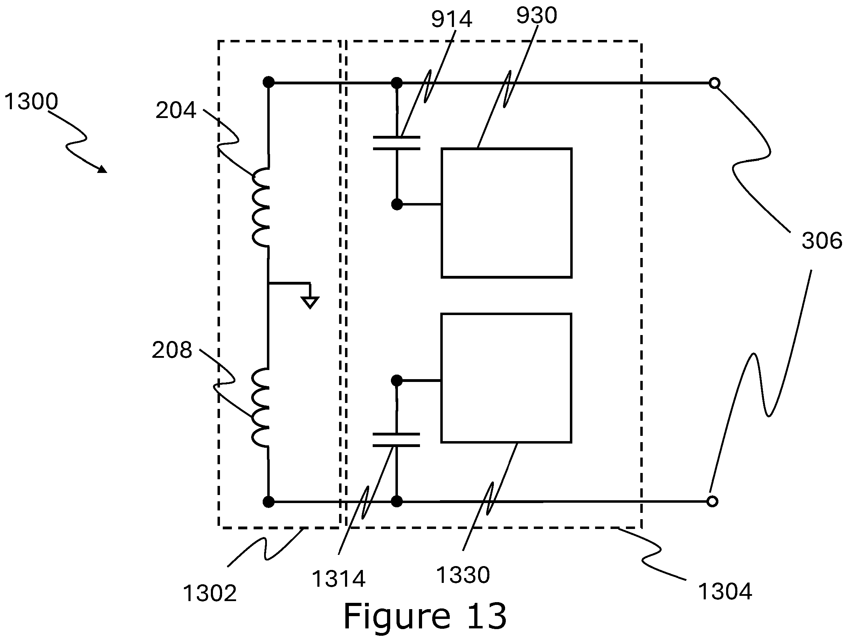

Figure 13 shows a differential system 1300 comprising a first measurement coil 204 and a second measurement coil 208 coupled to one another and a ground or reference voltage. The resonant frequency of the first coil 204 may be modified by first capacitor 914 and first variable voltage system 930. The variable voltage system 930 may comprise any of the voltage or current amplifiers described previously.

In addition, a second capacitor 1314 and a second variable voltage system 1330 are provided. These act to modify the resonant frequency of the second current measurement coil 208. The variable voltage system 1330 may comprise any of the voltage or current amplifiers described previously.

Notably, the resonant frequencies of the first coil 204 and the second coil 208 may be modified in the same way or in different ways. Where the resonant frequencies are modified in different ways, the first combined resonant frequency (of the first coil 204 and first capacitor 914) is different to the second combined resonant frequency (of the second coil 208 and the second capacitor 1314). This may allow the coils to have peak SNR at different frequencies, allowing the coils to focus on different frequencies relevant to arc-faults or other fault types.

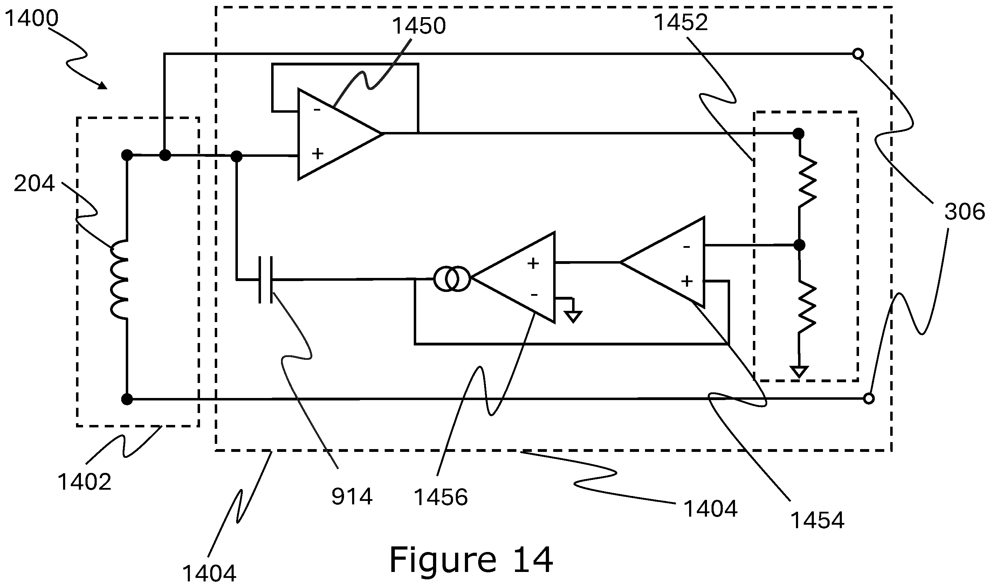

Figure 14 shows a further current sensor system 1400 comprising a measurement coil 1402 and a variable resonant frequency modification system 1404 comprising a transconductance amplifier.

The coil voltage is provided as an input to a first amplifier 1450, which may act as a buffer amplifier to buffer the voltage. The output of the first amplifier 1450 is provided across a potential divider circuit 1452. An output (or midpoint) of the potential divider circuit is provided as an input to a second amplifier 1454, which may act as a second buffer amplifier to buffer the voltage. The voltage input to the second amplifier 1454 may be varied by varying the resistances of the potential divider 1452.

An output of the second buffer amplifier 1454 is provided as an input to a transconductance amplifier 1456. Put another way, the input to the transconductance amplifier is a scaled (amplified or attenuated) version of the voltage across the coil. The transconductance amplifier provides an output current to the second plate of capacitor 914 proportional to the input voltage supplied by the second amplifier 1454. As such, the current supplied to the second plate of the capacitor 914, used to charge and discharge the capacitor 914, is proportional to the scaled version of the voltage of the measurement coil 204.

Modifying the current supplied to the capacitor 914 (forced into or pulled from the capacitor 914) using the transconductance amplifier 1456 modifies the effective capacitance coupled to the measurement coil 204. This changes the combined resonant frequency of the measurement coil 1402 and the variable resonant frequency modification circuit 1404. As noted previously, this may be applied to single-ended or differential coils, allowing variable control over a single coil or multiple coils resonant frequency.

Output nodes 306 show that the output of the system may be taken directly from the measurement coil 204. However, it should be understood that the output may be taken from the output of the buffer amplifier 1450.

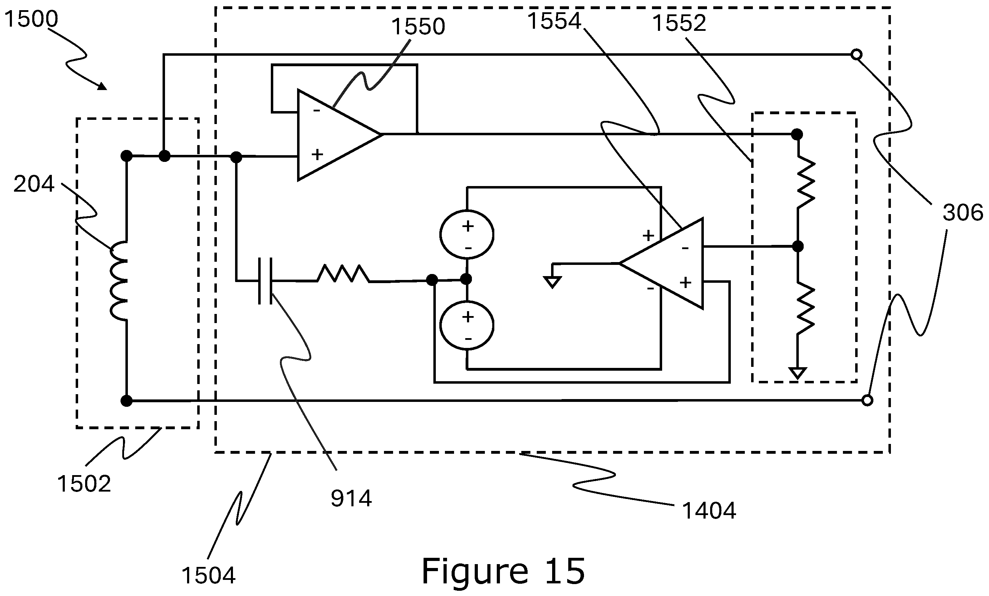

Figure 15 shows the current sensor system 1500 comprising the current measurement coil 1502 and the variable resonant frequency modification circuit 1504. The variable frequency modification circuit 1504 comprises a capacitor 914, with a first plate of the capacitor coupled to a an output terminal of the measurement coil 204. This output is also coupled to a first amplifier 1550, which acts as a buffer or attenuating stage.

The output of the first amplifier is coupled toa potential divider 1552, which acts to provide an input to second amplifier 1554. The gain of the second amplifier 1554 is set by the ratio of the resistors or impedances of the potential divider 1552.

Contrary to normal use, the output pin or terminal of the second amplifier 1554 is coupled to ground. The output from the second amplifier 1554 is instead provided by the supply + and - pins of the amplifier 1554., which traditionally are connected to a power supply. The supply + and - pins are coupled the second plate of the capacitor 914 through a resistor. By changing the ratio of resistances of the potential divider 1552, for example using a potentiometer or variable resistor, the perceived capacitance of capacitor 914 may be modified. The amplifiers may act to attenuate or add gain to a signal.

If a differential coil 1502 were provided, a second capacitor would be coupled in a similar manner to a second output of the measurement coil. This second capacitance may be modified using a similar circuit, allowing the two coils to have different variable combined resonant frequencies. Further, a single capacitor could be coupled to a differential coil to provide the same combined resonant frequency for both coils.

As described with respect to Figure 14, output nodes 306 show that the output of the system may be taken directly from the measurement coil 204. However, it should be understood that the output may be taken from the output of the buffer amplifier 1550.

In these circuits, the variability of the voltage across the capacitor can be achieved by changing the values of the potential divider 1552, which allows the effective capacitance coupled to the measurement coil 1502 to be modified. This active approach creates a variable capacitor effect, allowing for a wide range of frequency adjustments with more precision. The gain of the feedback loop can be further adjusted, for example, through a digital-to-analog converter (DAC), to dynamically change the resonant frequency. This allows for precise control over the frequency at which the coil is most sensitive, enabling the detection of arc faults across a range of frequencies.

A system may be provided that combines the previously described active and passive resonant frequency adjustment methods. The capacitor value may be modified by changing the capacitance directly by varying the value of the capacitor. This may be achieved, for example, using the previously described switched capacitor implementation in place of the capacitor in the active circuits to switch in and out different capacitors. In addition, the active control of the coupled capacitance may be modified using the amplified approach described in the active methods.

Frequency selectable measurements as described above are required in many fields. Sometimes the fundamental problem that drives this need is the fact that noise is the limiting factor determining measurement sensitivity. This is the case behind the chopper stabilized amplifier and the lock-in amplifier, whereby the parameter to be measured is often identical across frequency and noise is the only issue. In other applications such as radio, like the ACFI (arc fault circuit interrupt), the issue is not only noise but also information selectivity. The previously described circuit and techniques may be applied to radio, radio antenna tuning, ACFI (Arc fault measurements), chopper type amplifiers, and lock-in amplifiers.

Various modifications whether by way of addition, deletion, or substitution of features may be made to the above described examples to provide further examples, any and all of which are intended to be encompassed by the appended aspects.

### Aspects

Non-limiting aspects of the disclosure are set out in the following numbered clauses.

### First set of numbered aspects

1. A current sensor system comprising: a current measurement coil configured to measure the current flowing through a conductor;
   a resonant frequency modification circuit coupled to the current measurement coil, the resonant frequency modification circuit configured to modify the resonant frequency of the current sensor system to be different from a self-resonant frequency of the current measurement coil alone.
2. The current sensor system of aspect 1, wherein the resonant frequency modification circuit comprises one or more reactive components that act with the reactance of the current measurement coil to modify the resonant frequency of the current sensor system.
3. The current sensor system of aspect 2, wherein the reactive components comprise capacitors that present a capacitance across the current measurement coil.
4. The current sensor system of any preceding aspect, wherein the resonant frequency modification circuit is configured to provide a fixed resonant frequency for the current sensor system.
5. The current sensor system of any of aspects 1-3, wherein the resonant frequency modification circuit comprises a variable resonant frequency modification circuit configured to provide a changeable or modifiable resonant frequency for the current sensor system.
6. The current sensor system of aspect 5, wherein the variable resonant frequency modification circuit comprises a switched capacitor arrangement configured to couple or de-couple capacitors across the current measurement coil to modify the resonant frequency.
7. The current sensor system of aspect 6, wherein the switched capacitor arrangement comprises two or more individually controllable switched capacitors.
8. The current sensor system of aspect 5, wherein the variable resonant frequency modification circuit comprises a system configured to tune a capacitor coupled across the current measurement coil using a variable gain amplifier to modify the effective capacitance of the capacitors.
9. The current sensor system of any preceding aspect, wherein the current measurement coil is provided on a printed circuit board.
10. The current sensor system of any preceding aspect, wherein the current measurement coil is a single-ended current measurement coil.
11. The current sensor system of any preceding aspect, wherein the current measurement coil is a differential current measurement coil.
12. The current sensor system of any preceding aspect, wherein the current sensor system is configured to sense an arc fault.
13. The current sensor system of any preceding aspect, further comprising a control system, the control system configured to:
   measure the current using the current measurement coil at a first time;
   modify the resonant frequency of the current sensor using the resonant frequency modification circuit;
   measure the current using the current measurement coil at a second time following modification of the resonant frequency.
14. The current sensor system of aspect 13, wherein the control system is configured to determine the presence of an arc-fault based on the measurements of current at the first time and the second time.
15. A resonant frequency modification circuit couplable to a current measurement coil, the resonant frequency modification circuit configured to modify the resonant frequency to be different from the self-resonant frequency of the current measurement coil alone.

### Second set of numbered aspects

1. A current sensor system comprising:
   a current measurement coil configured to measure the current flowing through a conductor, the current measurement coil having a self-resonant frequency;
   a resonant frequency modification circuit coupled to the current measurement coil, the resonant frequency modification circuit configured to modify a resonant frequency of the current sensor system such that a combined resonant frequency of the current measurement coil and the resonant frequency modification circuit is different from the self-resonant frequency of the current measurement coil.
2. The current sensor system according to aspect 1, wherein the resonant frequency modification circuit comprises one or more reactive components that act with the reactance of the current measurement coil to modify the combined resonant frequency.
3. The current sensor system according to aspect 2, wherein the reactive components comprise a capacitor coupled to the current measurement coil, wherein the capacitor presents a capacitance across the current measurement coil.
4. The current sensor system according to any preceding aspect, wherein the resonant frequency modification circuit is configured to provide a fixed combined resonant frequency.
5. The current sensor system according to any of aspects 1-3, wherein the resonant frequency modification circuit comprises a variable resonant frequency modification circuit configured to provide a modifiable combined resonant frequency.
6. The current sensor according to aspect 5, wherein the resonant frequency modification circuit is configured to modify an effective capacitance across the measurement coil to modify the combined resonant frequency.
7. The current sensor according to aspect 6, wherein the variable resonant frequency modification circuit is configured to modify a current that flows into a capacitor coupled to the measurement coil, thereby modifying the effective capacitance across the measurement coil.
8. The current sensor system according to any of aspects 5-6, wherein the variable resonant frequency modification circuit comprises:
   a capacitor, wherein a first plate of the capacitor is coupled to the current measurement coil;
   a variable voltage circuit, the variable voltage circuit coupled to a second plate of the capacitor and configured to modify a voltage coupled to the second plate of the capacitor.
9. The current sensor system according to aspect 8, wherein the variable voltage circuit comprises:
   an amplifier comprising an input coupled to the current measurement coil and an output coupled to the second plate of the capacitor,
   wherein the amplifier is configured to amplify or attenuate the input voltage and output an output voltage to the second plate of the capacitor.
10. The current sensor system according to aspect 9, wherein the amplifier is configured to modify the combined resonant frequency by modifying the effective capacitance of the capacitor.
11. The current sensor system according to any of aspects 5-7, wherein the variable resonant frequency modification circuit comprises:
   a capacitor, wherein a first plate of the capacitor is coupled to the current measurement coil;
   a transconductance amplifier, the transconductance amplifier configured to modify the current supplied to the capacitor.
12. The current sensor system according to any of aspects 5-11, wherein the variable resonant frequency modification circuit comprises a switched capacitor arrangement configured to couple or de-couple one or more capacitors across the current measurement coil to modify the combined resonant frequency.
13. The current sensor system according to any preceding aspect, wherein the switched capacitor arrangement comprises two or more individually controllable switched capacitors.
14. The current sensor system of any preceding aspect, wherein the current measurement coil is a single-ended current measurement coil.
15. The current sensor system according to aspect 1, the current sensor system further comprising:
   a second current measurement coil, the second current measurement coil coupled to the first current measurement coil in a differential arrangement; and
   a second resonant frequency modification circuit coupled to the second current measurement coil, the second resonant frequency modification circuit configured to modify the resonant frequency of the current sensor system such that a combined resonant frequency of the second current measurement coil and the second resonant frequency modification circuit is different from the self-resonant frequency of the second current measurement coil.
16. The current sensor system according to aspect 15, wherein the combined resonant frequency of the second current measurement coil and the combined resonant frequency of the first current measurement coil may be modified in different ways.
17. The current sensor system of any preceding aspect, wherein the current measurement coil is provided on a printed circuit board.
18. The current sensor system of any preceding aspect, wherein the current sensor system is configured to sense an arc fault.
19. The current sensor system of any preceding aspect, further comprising a control system, the control system configured to:
   measure the current using the current measurement coil at a first time;
   modify the combined resonant frequency using the resonant frequency modification circuit;
   measure the current using the current measurement coil at a second time following modification of the combined resonant frequency.
20. The current sensor system of aspect 19, wherein the control system is configured to determine the presence of an arc-fault based on the measurements of current at the first time and the second time.
21. A method of measuring current using a current sensor system comprising a current measurement coil having a self-resonant frequency and a resonant frequency modification circuit, the method comprising:
   modifying a resonant frequency of the current sensor system, such that a combined resonant frequency of the current measurement coil and the resonant frequency modification circuit is different from the self-resonant frequency of the current measurement coil.
22. The method according to aspect 21, further comprising:
   measuring the current using the current measurement coil at a first time;
   modifying the combined resonant frequency of the current measurement coil and the current sensor using the resonant frequency modification circuit;
   measuring the current using the current measurement coil at a second time following modification of the resonant frequency.
23. The method according to aspect 22, further comprising:
   determining the presence of an arc-fault based on the measured currents at the first time and the second time.
24. A current sensor system comprising:
   a current measurement coil configured to measure the current flowing through a conductor, the current measurement coil having a self-resonant frequency;
   a variable resonant frequency modification circuit coupled to the current measurement coil,
   the resonant frequency modification circuit configured to modify the resonant frequency of the current sensor system by:
      modifying an effective capacitance coupled across the measurement coil such that a combined resonant frequency of the current measurement coil and the variable resonant frequency modification circuit is different from the self-resonant frequency of the current measurement coil.

## Claims

1. A current sensor system comprising:
a current measurement coil configured to measure the current flowing through a conductor, the current measurement coil having a self-resonant frequency;
a resonant frequency modification circuit coupled to the current measurement coil, the resonant frequency modification circuit configured to modify a resonant frequency of the current sensor system such that a combined resonant frequency of the current measurement coil and the resonant frequency modification circuit is different from the self-resonant frequency of the current measurement coil.

2. The current sensor system according to claim 1, wherein the resonant frequency modification circuit comprises one or more reactive components that act with the reactance of the current measurement coil to modify the combined resonant frequency.

3. The current sensor system according to claim 2, wherein the reactive components comprise a capacitor coupled to the current measurement coil, wherein the capacitor presents a capacitance across the current measurement coil.

4. The current sensor system according to any preceding claim, wherein the resonant frequency modification circuit is configured to provide a fixed combined resonant frequency.

5. The current sensor system according to any of claims 1-3, wherein the resonant frequency modification circuit comprises a variable resonant frequency modification circuit configured to provide a modifiable combined resonant frequency.

6. The current sensor according to claim 5, wherein the resonant frequency modification circuit is configured to modify an effective capacitance across the measurement coil to modify the combined resonant frequency.

7. The current sensor according to claim 6, wherein the variable resonant frequency modification circuit is configured to modify a current that flows into a capacitor coupled to the measurement coil, thereby modifying the effective capacitance across the measurement coil.

8. The current sensor system according to any of claims 5-6, wherein the variable resonant frequency modification circuit comprises:
a capacitor, wherein a first plate of the capacitor is coupled to the current measurement coil;
a variable voltage circuit, the variable voltage circuit coupled to a second plate of the capacitor and configured to modify a voltage coupled to the second plate of the capacitor.

9. The current sensor system according to claim 8, wherein the variable voltage circuit comprises:
an amplifier comprising an input coupled to the current measurement coil and an output coupled to the second plate of the capacitor,
wherein the amplifier is configured to amplify or attenuate the input voltage and output an output voltage to the second plate of the capacitor.

10. The current sensor system according to claim 9, wherein the amplifier is configured to modify the combined resonant frequency by modifying the effective capacitance of the capacitor.

11. The current sensor system according to any of claims 5-7, wherein the variable resonant frequency modification circuit comprises:
a capacitor, wherein a first plate of the capacitor is coupled to the current measurement coil;
a transconductance amplifier, the transconductance amplifier configured to modify the current supplied to the capacitor.

12. The current sensor system according to any of claims 5-11, wherein the variable resonant frequency modification circuit comprises a switched capacitor arrangement configured to couple or de-couple one or more capacitors across the current measurement coil to modify the combined resonant frequency.

13. The current sensor system according to any preceding claim, the current sensor system further comprising:
a second current measurement coil, the second current measurement coil coupled to the first current measurement coil in a differential arrangement; and
a second resonant frequency modification circuit coupled to the second current measurement coil, the second resonant frequency modification circuit configured to modify the resonant frequency of the current sensor system such that a combined resonant frequency of the second current measurement coil and the second resonant frequency modification circuit is different from the self-resonant frequency of the second current measurement coil.

14. A method of measuring current using a current sensor system comprising a current measurement coil having a self-resonant frequency and a resonant frequency modification circuit, the method comprising:
modifying a resonant frequency of the current sensor system, such that a combined resonant frequency of the current measurement coil and the resonant frequency modification circuit is different from the self-resonant frequency of the current measurement coil.

15. The method according to claim 14, further comprising:
measuring the current using the current measurement coil at a first time;
modifying the combined resonant frequency of the current measurement coil and the current sensor using the resonant frequency modification circuit;
measuring the current using the current measurement coil at a second time following modification of the resonant frequency.
